# EUROPEAN PATENT APPLICATION

(11) **EP 1 610 400 A1**
(43) Date of publication of application: **28.12.2005**
(21) Application number: 05010146.8
(22) Date of filing: 10.05.2005
(51) Int. Cl.: H01M 2/02, H01M 10/42, H01M 6/50, H01M 10/50, H01M 10/04, H05K 1/18, H05K 1/11

(54) **Battery with embedded circuits**

(30) Priority: 07.06.2004 CN 200410045559
(71) Applicant: Antig Technology Co., Ltd., 114 Taipei (TW)
(72) Inventor: Shen, Ko-Chen, Tapei (TW)
(74) Representative: Vossius & Partner

(57) **Abstract**

The present invention relates to a battery with embedded circuits, including a battery unit, a control circuit layer, and packaging material. The battery unit is manufactured by a printed circuit board process. The control circuit layer is stacked with the battery unit to form a laminated structure, having at least: a circuit layer using the battery unit as a power source, and an electric contact layer electrically connected to the circuit layer. The electric contact layer has a plurality of electric contact points exposed outside the packaging material. The packaging material is for accommodating and sealing the battery unit and the control circuit layer.

## Description

The present invention relates to a battery; in particular, it relates to a battery embedded with circuits and self-provided with an internal power source. Additionally, the battery can be manufactured by a printed circuit board process.

The conventional methods for self-providing a power supply in a battery for embedded circuits are divided into 2 types. The first type uses a battery external to the embedded circuits and then uses anode and cathode power cables to connect the embedded circuits and the battery. The second type uses a battery packaged internally with the embedded circuits, and presents an integrally packaged structure on the overall exterior. Thus, the battery located internally cannot be seen with naked eyes from the exterior. However, the battery utilized as the power supply by this type of embedded circuit is a complete package by itself. The difference between the first and second types is merely to hide the anode and cathode cables inside. These two types of conventional methods both directly use an existing battery. Thus, subject to the limitation imposed by the battery, embedded circuits cannot be stacked with the battery to form a laminated structure. This limitation does not allow the embedded circuits with self-provided battery power supply to further reduce the overall size.

Based on the drawbacks of the conventional methods mentioned above, the inventor of the present invention improves the battery with embedded circuits, allowing the embedded circuits and the battery to stack into a lamented integral structure.

One aspect of the present invention is to provide a battery embedded with circuits and having an internal self-provided power source.

Another aspect of the present invention is to provide a battery embedded with circuits that can be manufactured by a printed circuit board process.

In order to obtain the above mentioned aspects, the present invention provides a battery with embedded circuits, comprising: a battery unit manufactured by a printed circuit board process; and a control circuit layer stacked with the battery unit to form a laminated structure. The control circuit layer includes at least: a circuit layer having at least one electronic element and using the battery unit as the power source; an electric contact layer electrically connected to the circuit layer and having a plurality of electric contact points, wherein the plurality of electric contact points are exposed outside the packaging material; the packaging material accommodating and sealing the battery unit and the control circuit layer.

The above objects and advantages of the present invention will become more apparent with reference to the appended drawings wherein:
FIG 1 shows an exterior view of an embodiment of the battery with embedded circuits in accordance with the present invention;
FIG 2 shows an exploded internal structural view of the embodiment of FIG. 1;
FIG 3 shows an elevational view of the embodiment of FIG 1;
FIG. 4 shows an exploded structural view of an embodiment of a battery unit in accordance with the present invention;
FIG 5 shows a cross-sectional view of the embodiment of FIG 4;
FIG 6 shows an exploded structural view of an embodiment of a control circuit layer in accordance with the present invention;
FIG 7 shows another embodiment of an electric contact layer of the present invention; and
FIG 8 shows an elevational view of a heat-dissipating sheet laminated on top of the control circuit layer in accordance with the present invention.

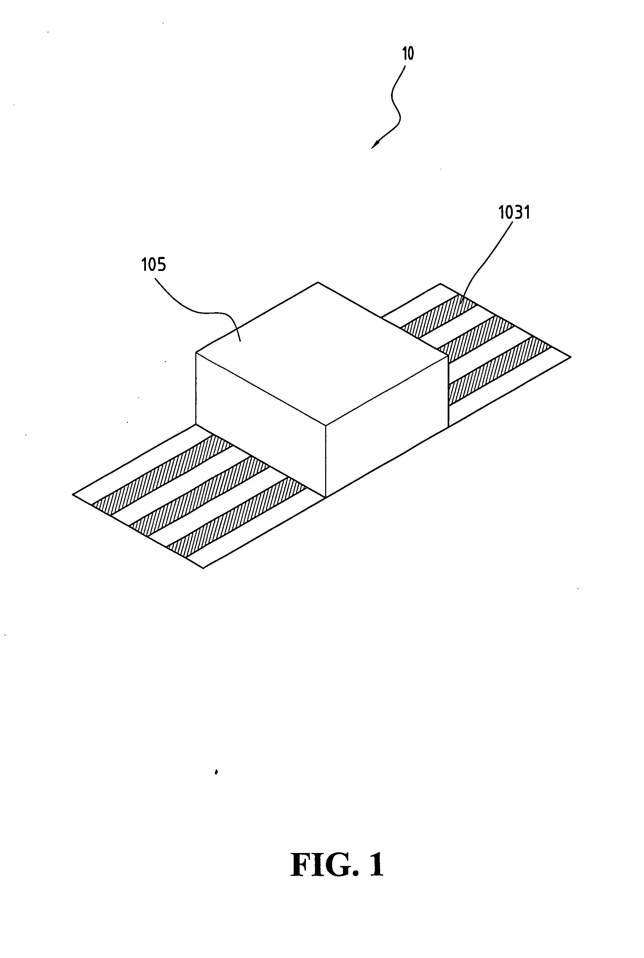

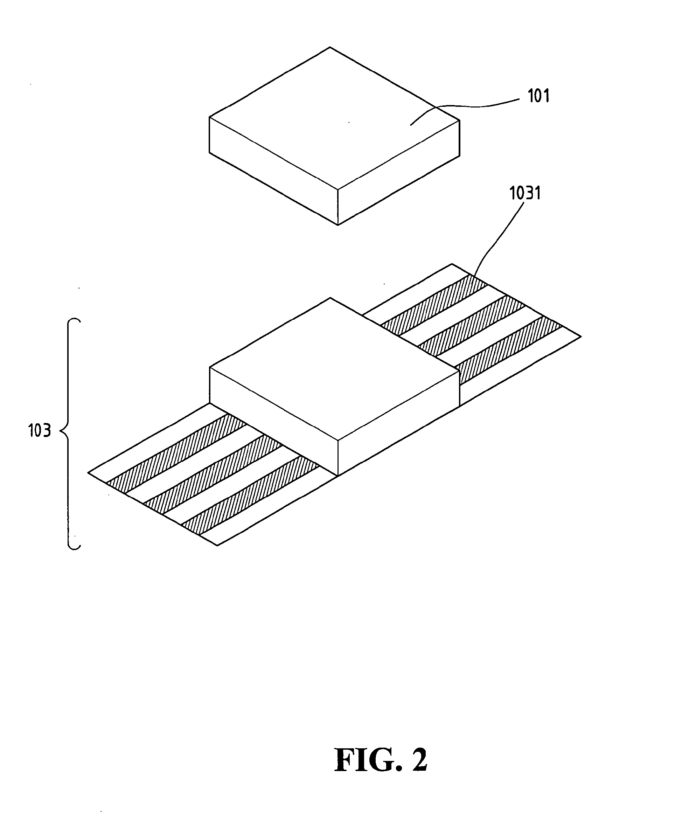

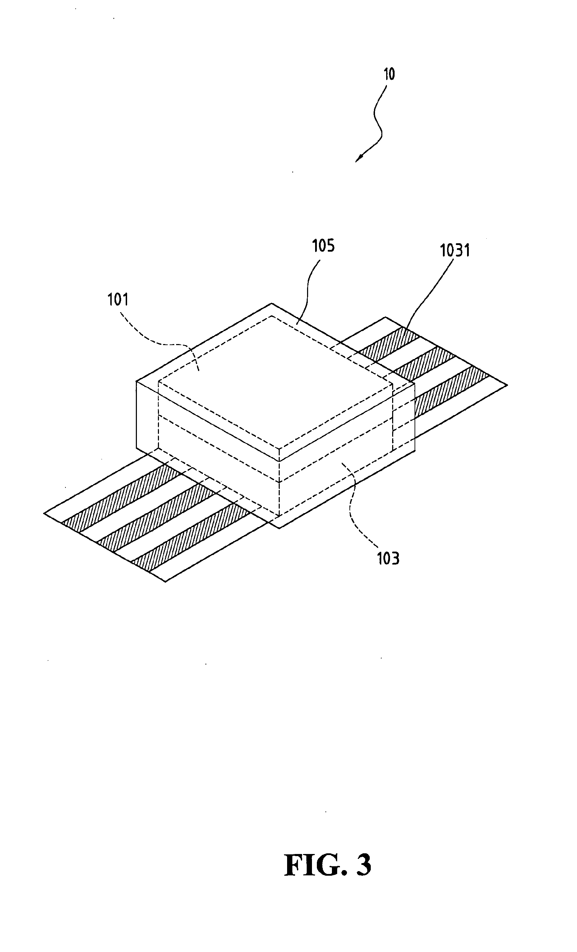

FIG 1 shows an exterior of an embodiment of a battery with embedded circuits in accordance with the present invention, FIG 2 shows an exploded structural view of the interior of the embodiment of FIG 1, and FIG 3 shows an elevational view of the embodiment of FIG 1. The battery with embedded circuits 10 of the present invention utilizes a packaging material 105, such as an Epoxy resin, to hermetically seal a battery unit 101 and a control circuit layer 103 within the Epoxy resin. A plurality of electric contact points 1031 are extended from the control circuit layer 103 and are exposed externally. The battery unit 101 and the control circuit layer 103 of the present invention are stacked together to form a laminated structure, and the battery unit 101 and the control circuit layer 103 of the present invention are both manufactured by a printed circuit board process. The power required by the control circuit layer 103 is supplied by the battery unit 101, while the plurality of electric contact points 1031 provided by the control circuit layer 103 are used for electrically connecting to an external electronic device, such as to solder to a computer mother board, or to electrically connect to another circuit board.

The manufacturing means utilized by the present invention can be a turnkey dispensing process or a tapping process using high polymer resin or Epoxy resin so as to hermetically seal the battery unit 101 and the control circuit layer 103 within the high poly resin or the Epoxy resin. After completion, it is heated between the temperature range of 40~120 so as to harden, thereby completing the exterior mold. The above-mentioned manufacturing means can be standardized with a plane or taping printing for mass production, and then utilize printing, shift printing, or screen printing to add exterior markings, such as anode and cathode markings, etc. The advantages of utilizing a high polymer resin to implement the packaging material 105 are as follows:
1. High heat conductivity;
2. High heat resistance; and
3. Moist-proof and corrosion-proof.

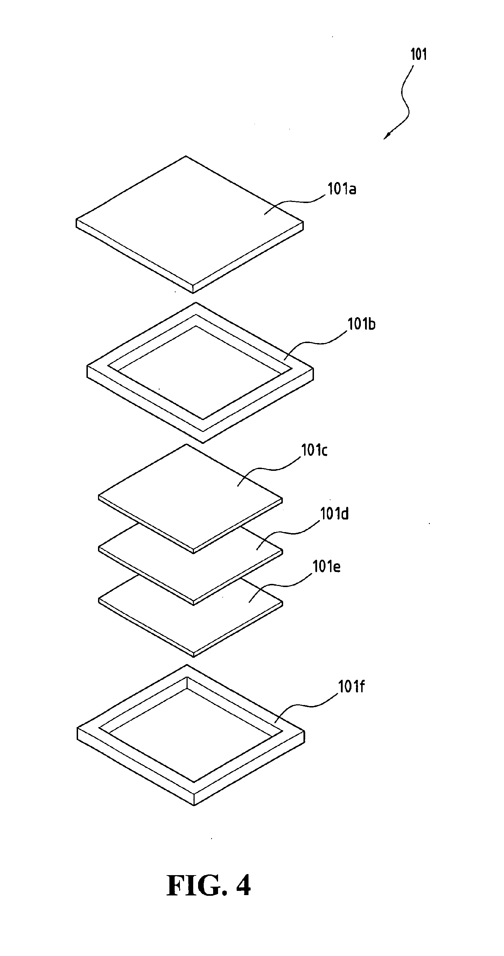

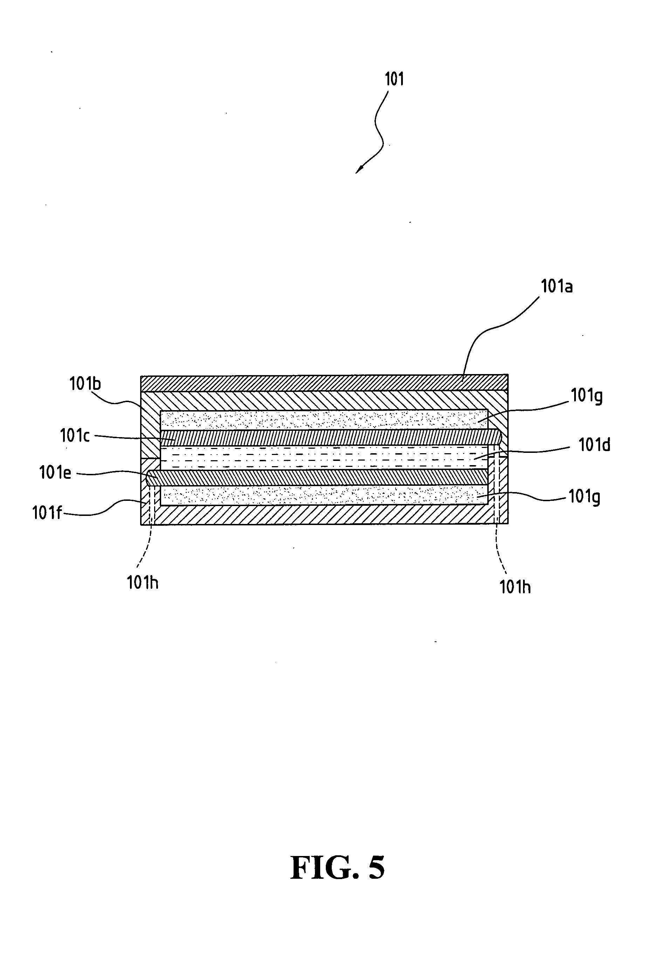

FIG 4 shows an exploded structural view of an embodiment of the battery unit in accordance with the present invention, and FIG 5 shows a cross-sectional view of the embodiment of FIG 4. An embodiment of the battery unit 101 can be a primary battery, or a secondary battery. The battery unit 101 of the present invention is characterized in that the battery unit 101 can be manufactured by a printed circuit board process. The battery unit 101 includes a cover 101a, an upper containing tank 101b, an anode 101c, a separating membrane 101 d, a cathode 101e, a lower containing tank 101f, and an electrolyzed material 101 g. These components are stacked from top to bottom to form a laminated structure. The cover 101a, the upper containing tank 101b, and the lower containing tank 101f are all manufactured with PCB material. The PCB material used can be FR4 material or a flexible circuit board. In assembling the battery unit 101 of the present invention, the upper containing tank 105 and the lower containing tank 107 are used for containing the electrolyzed material 101g. These components shown in FIG. 4 can use a laminating means such as pressing, and tapping to complete. The selection of the electrolyzed material 101g is subject to what kind of primary battery or secondary battery is used. Furthermore, via holes 101h are injected with a conductive material, such as silver adhesive. The ends of the via holes 101h are electrically connected to an anode 101c and a cathode 101e respectively, while the other ends are electrically connected to the control circuit layer 103 respectively.

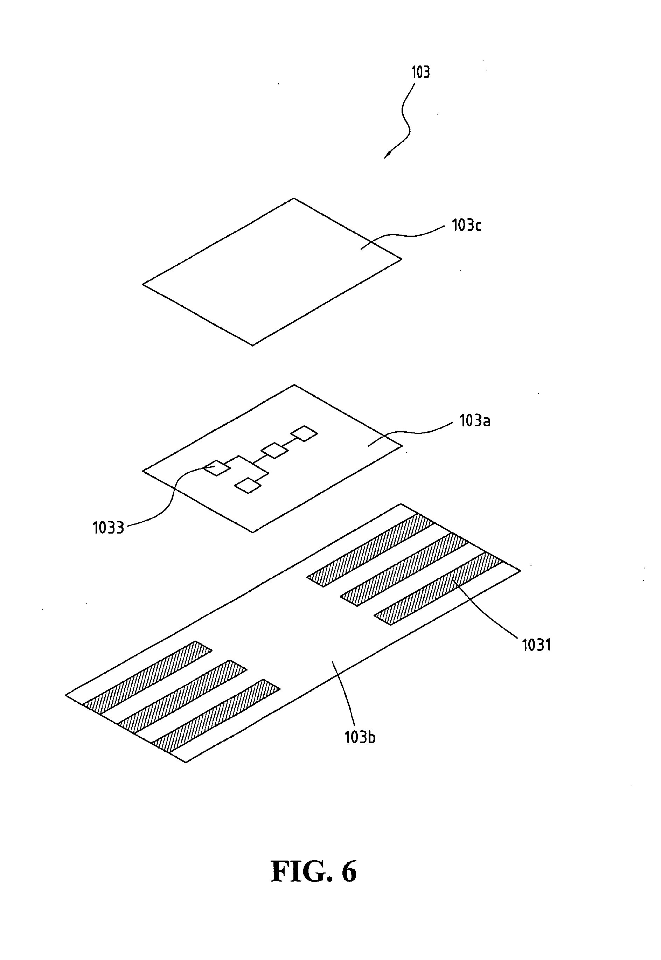

FIG 6 shows an exploded structural view of an embodiment of the control circuit layer in accordance with the present invention. An embodiment of the control circuit layer 103 can be a circuit board using a multi-layer printed circuit board as substrate. The material of the substrate can be selected from FR4 material or a flexible circuit board. In FIG. 6, the circuit layer 103a is soldered to at least one of the electronic elements 1033. These electronic elements 1033 form into a circuit, such as an emitting circuit. As mentioned above, the power source of these electronic elements 1033 is supplied by the battery unit 101. These electronic elements 1033 can individually connect to the anode 101c and the cathode 101e through the via holes 101h. Furthermore, the circuit layer 103a is one layer of the laminated inner layers within the multi-layer printed circuit board. The top layer of the circuit layer 103a is covered with another printed circuit board 103c. The electric contact layer 103b can be the outermost layer of the multi-layer printed circuit board, having a plurality of electric contact points 1031. Or it can be a layer in the laminated inner layers, extending the plurality of the electric contact points 1031 outside. The electric contact layer 103b in FIG 6 can be a flexible flat cable having a flexible printed circuit board as substrate, or can be a printed circuit board having a gold finger.

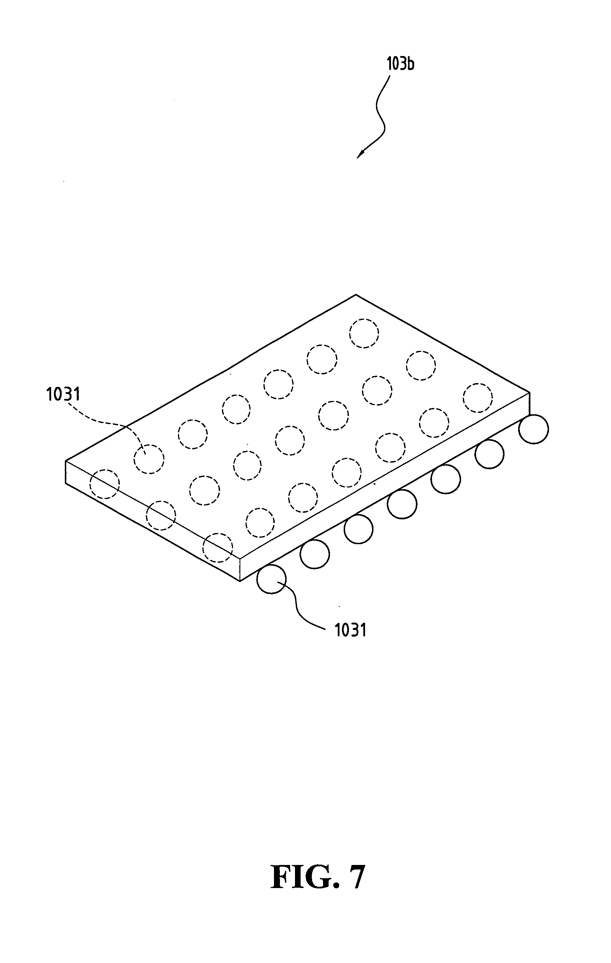

FIG. 7 shows another embodiment of the electric contact layer of the present invention. The plurality of the electric contact points 1031 of the electric contact layer 103b can be contact points in ball grid arrays. These ball shape contact points 1031 are exposed outside the packaging material 105. The electric contacting points 1031 in FIGs. 6 and 7 are all electrically connected to the electronic elements 1033, and become the pins for the battery with embedded circuits 10, thereby allowing electric signal transmission between the external electronic device and the circuit layer 103 a through the electric contact points 1031.

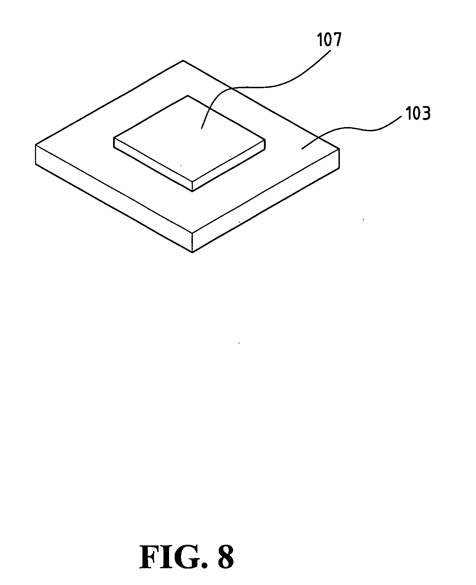

FIG 8 shows an elevational view of a heat-dissipating sheet laminated on top of the control circuit layer in accordance with the present invention. The heat-dissipating sheet 107 is laminated between the control circuit layer 103 and the battery unit 101, mainly for dissipating the heat generated by the battery unit 101 during operation. An embodiment of the heat-dissipating sheet 107 can be a meshed metal sheet with a plurality of penetrating ventilation holes, or a sheet made of silicon dioxide.

The battery with embedded circuits of the present invention is manufactured by the printed circuit board process so as to integrally assemble the battery with the embedded circuits. Meanwhile, the embedded circuits completely use the battery assembled together as the power source, and thus the embedded circuits can perform without an external power source.

The battery with embedded circuits and the manufacturing method thereof in accordance with the present invention have the following advantages:
1. It can be manufactured as high-density connected electric contact points to conform with the product requirement of being light, slim, and small;
2. It can integrate production manufacturing cost and material cost to conform with economic efficiency;
3. Easy usage and management on electricity and easy management on heat generation;
4. It can be used and soldered repeatedly, and thus maintenance is easy;
5. It has a lower circuit resistance, and thus can enhance the rate of process filtering; and
6. It conforms to a variety of requirements for voltage supply and current supply.

Although the present invention has been disclosed with the embodiments above, these embodiments are not intended to limit the present invention. A variety of modifications and changes can be made by those skilled in the art without leaving the spirit and scope of the present invention. The modifications and changes are within the scope of the present invention. The protected scope of the present invention is set forth in the following claims.

## Claims

1. A battery with embedded circuits, comprising:
a battery unit manufactured by a printed circuit board process;
a control circuit layer stacked with said battery unit to form a laminated structure, having at least:
a circuit layer using said battery unit as power source, having at least one electronic element;
an electric contact layer electrically connected to said circuit layer, having a plurality of electric contact points, wherein said plurality of electric contact points are exposed outside a packaging material;
said packaging material accommodating and sealing said battery unit and said control circuit layer.

2. The battery with embedded circuits of claim 1, wherein said control circuit layer is a multi-layer printed circuit board.

3. The battery with embedded circuits of claim 2, wherein said circuit layer is a layer of said multi-layer printed circuit board.

4. The battery of claim 2 or 3, wherein said electric contact layer is a layer of said multi-layer printed circuit board.

5. The battery of claim 1, 2, 3 or 4, wherein a substrate of said control circuit layer is selected from an FR4 printed circuit board and a flexible printed circuit board.

6. The battery of claim 1, 2 , 3 , 4 or 5, wherein said electronic element is an integrated circuit (IC).

7. The battery of any one of claims 1 to 6, wherein said packaging material is selected from an Epoxy resin and a high polymer resin.

8. The battery of any one of claims 1 to 7, wherein said electric contact layer is a flexible printed circuit board with said plurality of electric contact points.

9. The battery of any one of claims 1 to 8, wherein said electric contact layer is an FR4 printed circuit board with said plurality of electric contact points.

10. The battery of any one of claims 1 to 9, wherein said battery unit is a secondary battery.

11. The battery of any one of claims 1 to 10, wherein said battery unit is a primary battery.

12. The battery of any one of claims 1 to 11, wherein said plurality of electric contact points is in a ball grid array.

13. The battery of any one of claims 1 to 12, wherein said plurality of electric contact points is a flexible flat cable having a flexible printed circuit board as substrate.

14. The battery of any one of claims 1 to 13, wherein said plurality of electric contact points is a gold finger having a printed circuit board as substrate.

15. The battery of any one of claims 1 to 14, further comprising a heat dissipating sheet for dissipating the heat generated by said battery unit.

16. The battery with embedded circuits of claim 15, wherein said heat dissipating sheet is laminated between said battery unit and said control circuit layer.
